(19) **Europäisches Patentamt / European Patent Office / Office européen des brevets**

(11) **EP 1 390 786 B1**

(12) **FASCICULE DE BREVET EUROPEEN**

(45) Date de publication et mention
de la délivrance du brevet:
**30.07.2008 Bulletin 2008/31**

(21) Numéro de dépôt: **02706867.5**

(22) Date de dépôt: **18.02.2002**

(51) Int Cl.:
*G02B 6/28* (2006.01)   *H01S 5/40* (2006.01)

(86) Numéro de dépôt international:
**PCT/FR2002/000609**

(87) Numéro de publication internationale:
**WO 2002/067028 (29.08.2002 Gazette 2002/35)**

(54) **COMPOSANT DE COUPLAGE REALISE EN OPTIQUE INTEGREE**

INTEGRIERTER OPTISCHER BAUTEIL ZUR KOPPLUNG

INTEGRATED-OPTICS COUPLING COMPONENT, DESIGNED TO ADAPT A LIGHT SOURCE TO A GUIDED OPTICS ELEMENT AND POWER LASER COMPRISING SAME

(84) Etats contractants désignés:
**AT BE CH CY DE DK ES FI FR GB GR IE IT LI LU MC NL PT SE TR**

(30) Priorité: **19.02.2001 FR 0102223**

(43) Date de publication de la demande:
**25.02.2004 Bulletin 2004/09**

(73) Titulaire: **Teem Photonics
38240 Meylan (FR)**

(72) Inventeurs:
- **BARBIER, Denis
F-38000 Grenoble (FR)**
- **BENECH, Pierre
F-38000 Grenoble (FR)**

(74) Mandataire: **Jouvray, Marie-Andrée et al
Cabinet Hecké,
World Trade Center - Europole,
5, place Robert Schuman,
B.P. 1537
38025 Grenoble Cedex 1 (FR)**

(56) Documents cités:
**EP-A- 0 593 081        US-A- 5 142 596
US-A- 5 513 196**

- **LORENZO R M ET AL: "METHOD OF ACHIEVING PHASE DELAY WITH WIDE OPTICAL BANDWIDTH IN MULTIMODE INTERFERENCE DEVICES" OPTICS LETTERS, OPTICAL SOCIETY OF AMERICA, WASHINGTON, US, vol. 23, no. 22, 15 novembre 1998 (1998-11-15), pages 1748-1750, XP000802116 ISSN: 0146-9592**
- **SCHANEN DUPORT I ET AL: "NEW INTEGRATED-OPTICS INTERFEROMETER IN PLANAR TECHNOLOGY" APPLIED OPTICS, OPTICAL SOCIETY OF AMERICA, WASHINGTON, US, vol. 33, no. 25, 1 septembre 1994 (1994-09-01), pages 5954-5958, XP000473279 ISSN: 0003-6935**

Printed by Jouve, 75001 PARIS (FR)

## Description

### Domaine technique de l'invention

L'invention concerne un composant de -couplage réalisé en optique intégrée à partir d'un substrat optique dans lequel sont formés des guides d'onde.

### État de la technique

Dans les télécommunications optiques, on utilise fréquemment des amplificateurs optiques. Classiquement, la fonction d'amplification est réalisée par injection simultanée, dans une fibre optique ou dans un guide d'onde réalisé en optique intégrée, d'un signal optique à amplifier, de puissance Pe (puissance d'entrée) et de longueur d'onde $\lambda$s, et d'un signal de pompe, de puissance Pp (puissance de pompe) et de longueur d'onde $\lambda$p. On obtient ainsi un signal optique amplifié, de puissance (puissance de sortie) Ps=GPe, G étant le gain de l'amplificateur optique. Le gain G est d'autant plus important que la puissance de pompe est grande. Celle-ci est typiquement comprise entre 100 et 1000mW dans les amplificateurs optiques actuels ayant une longueur d'onde $\lambda$s de l'ordre de 1,55 $\mu$m et utilisant de la silice ou des verres, par exemple dopés avec des ions terres rares.

De telles puissances de pompe ne peuvent actuellement être fournies que par des diodes laser de pompe à semi-conducteur, de type multimode transverse.

Les diodes de pompe connues sont constituées soit par des diodes monoruban, de grande largeur, c'est-à-dire typiquement d'une largeur d'une centaine de micromètres, soit par des diodes multirubans. Ces types de diodes lasers émettent sur un nombre souvent important de modes, de directions spatiales différentes.

Or, les fibres optiques ou les guides d'onde optiques destinés à assurer la propagation du signal optique à amplifier et du signal de pompe sont généralement des structures monomodes ou à nombre de modes limité. Il y a en conséquence une forte différence dans la répartition d'amplitude spatiale émise par la diode laser de puissance utilisée comme diode de pompe et la répartition d'amplitude du mode pouvant se propager dans un guide optique intégré ou dans une fibre optique. Cette mauvaise adaptation se traduit, en pratique, par de faibles rendements d'injection de puissance de la diode laser vers la structure amplificatrice. Pour obtenir un gain d'amplification donné, il est alors nécessaire de surdimensionner la puissance de la diode laser de pompe, ce qui augmente le coût de la diode lasser et sa consommation électrique en fonctionnement. Inversement, pour une puissance de pompe prédéterminée, les gains d'amplification qui peuvent être obtenus sont relativement faibles.

Le brevet US 5513196 divulgue une structure couplée à une diode laser, sélectionnant le mode transverse fondamental et destinée à réaliser une sélection en fréquence.

### Objet de l'invention

L'invention a pour but de remédier aux inconvénients des dispositifs connus et de fournir un composant de couplage permettant, en particulier, de tirer le meilleur parti possible, avec une bonne stabilité d'émission, de la puissance émise par une diode laser de puissance utilisée notamment dans les amplificateurs optiques.

Selon l'invention, ce but est atteint par un composant de couplage selon les revendications annexées.

Le composant de couplage selon l'invention est réalisé en optique intégrée, destiné à adapter une source lumineuse à un élément d'optique guidée et comporte un substrat optique, dans lequel sont formés des guides d'onde, et successivement une zone de guidage d'entrée, disposée en regard de la source, une zone de sortie comportant au moins un guide d'onde de sortie, monomode, plus étroit que la zone de guidage d'entrée, et des moyens de filtrage comportant au moins une zone de rétrécissement adiabatique connectant la zone de guidage d'entrée et la zone de sortie. Il est caractérisé en ce que la zone de guidage d'entrée définit une zone de diffraction de longueur prédéterminée entre l'entrée du composant et un plan d'observation, au moins deux fenêtres de filtrage, disposées en des emplacements prédéterminés du plan d'observation, constituant les entrées des zones de rétrécissement adiabatique, de manière à guider une onde lumineuse de la source vers la zone de sortie en sélectionnant un des modes de ladite onde.

Dans un mode de réalisation préférentiel, L étant la largeur de la zone de guidage illuminée en entrée et $\lambda$ la longueur d'onde de la lumière émise par la source lumineuse, la longueur de la zone de diffraction est supérieure ou égale à $L^2/4\lambda$ et, de préférence supérieure ou égale à 2,5mm.

Selon un développement de l'invention, des moyens réflecteurs sont associés au guide d'onde de sortie et le composant est destiné à coopérer avec une source lumineuse multimode transverse, comportant une face arrière réfléchissante et une face émettrice, pour former un laser de puissance monomode transverse, la face émettrice de la source lumineuse étant traitée de manière à former une face externe antireflet, de manière à délimiter une cavité laser étendue oscillant sur un seul mode prédéterminé entre ladite face arrière et les moyens réflecteurs.

Les moyens réflecteurs peuvent comprendre un réseau de Bragg, une couche réfléchissante disposée à une extrémité de sortie de la zone de sortie ou une boucle fermée à l'extrémité de sortie du guide d'onde de sortie, associée à au moins un coupleur permettant un prélèvement d'une fraction de la lumière générée.

L'invention concerne également un laser de puissance monomode comportant une diode laser multimode comportant une cavité laser interne délimitée par une face arrière réfléchissante et une face émettrice, comportant un composant de couplage selon l'invention, la face émettrice de la diode laser étant traitée de manière à former une face externe antireflet, de manière à délimiter une cavité laser étendue entre ladite face arrière et des moyens réflecteurs.

**Description sommaire des dessins**

D'autres avantages et caractéristiques ressortiront plus clairement de la description suivante de modes particuliers de réalisation, donnés à titre d'exemples non limitatifs et représentés sur les dessins annexés dans lesquels :

Les figures 1 à 5 représentent différents modes de réalisation d'un composant de couplage.

Les figures 6 à 8 représentent, sous forme schématique, la structure d'entrée d'un composant de couplage, respectivement avec un, deux et quatre lobes de diffraction.

Les figures 9 à 11 illustrent plus en détail des modes particuliers de réalisation des éléments réflecteurs d'un composant de couplage selon l'invention.

La figure 12 représente plus en détail un mode particulier de réalisation d'une extrémité de la zone de sortie d'un composant de couplage selon l'invention.

Les figures 13 à 15 représentent plus en détail des modes particuliers de réalisation du couplage entre une diode laser et un composant de couplage selon l'invention.

La figure 16 illustre le couplage d'une source laser et d'un composant de couplage selon l'invention par l'intermédiaire d'un élément optique d'adaptation.

**Description de modes particuliers de réalisation.**

Le composant de couplage est réalisé en optique intégrée. Il est réalisé à partir d'un substrat optique 1 dans lequel sont formés des guides d'onde et il est destiné à coopérer avec une source lumineuse telle que par exemple une diode laser 2 de puissance multimode transverse, à semi conducteur. Il permet d'adapter la source 2 à un élément d'optique guidé non représenté tel que par exemple une fibre optique, ou un amplificateur optique guidé ou tout composant nécessitant l'utilisation d'une source d'onde monomode de préférence de forte puissance.

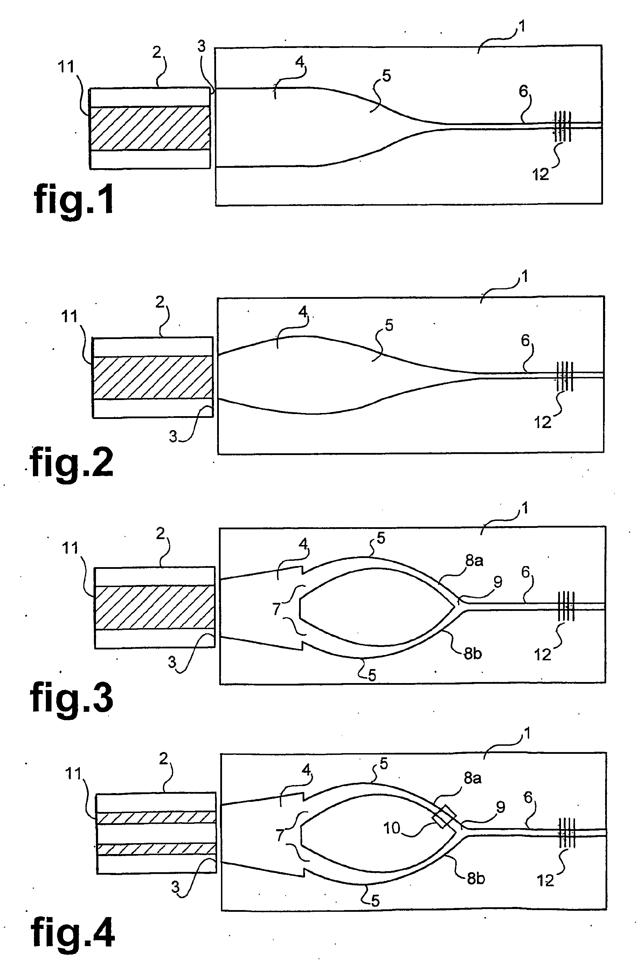

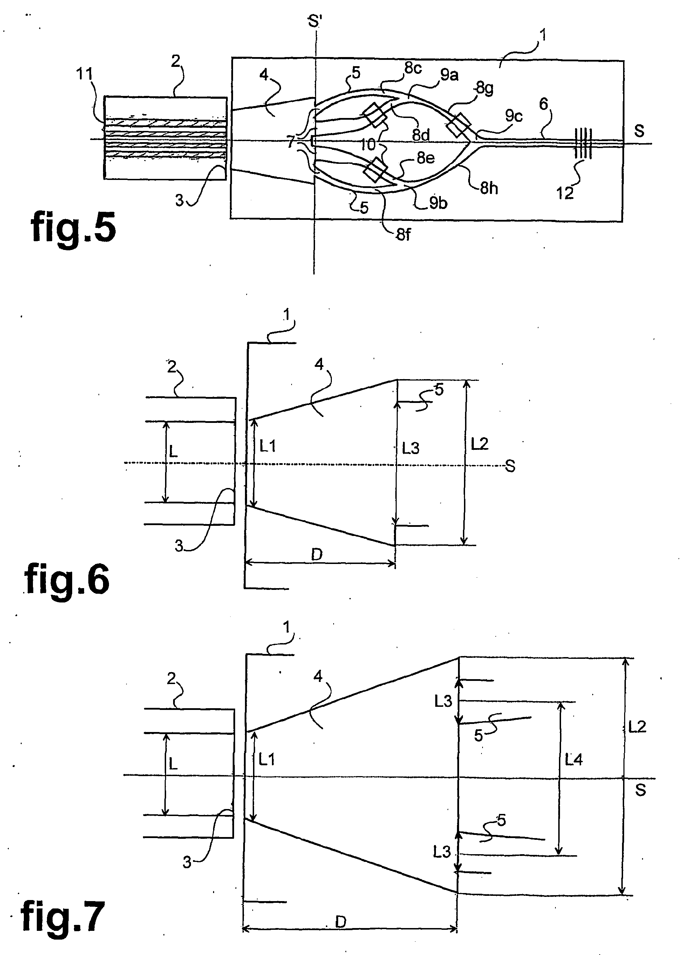

La diode laser 2 peut être une diode laser monoruban large (figures 1 à 3) ou une diode laser multiruban (figures 4, 5 et 8). L'élargissement du ruban dans une diode laser monoruban ou l'utilisation d'une pluralité de rubans étroits dans une diode laser multiruban permet d'augmenter la puissance lumineuse émise. Le couplage entre les rubans étroits, qui sont monomodes, dans une diode laser multiruban provoque, comme dans une diode laser monoruban large, l'émission d'une multitude de modes transverses. À titre d'exemple, une diode laser à ruban de largeur L=100$\mu$m (figure 6) peut émettre sur environ 200 modes transverses. Dans les deux cas, les caractéristiques d'émission de la diode laser de puissance sont peu compatibles avec l'injection de la lumière dans un guide d'onde ou dans une fibre optique monomode.

Sur les figures 1 à 8 et 16, la diode 2 et le composant de couplage sont représentés en vue de dessus, parallèlement à un plan dans lequel est réalisée la jonction semi-conductrice de la diode. Un axe longitudinal S de symétrie de la diode laser 2 et du composant de couplage, parallèle à la direction de propagation de la lumière à la sortie de la diode laser 2, est représenté sur les figures 5 à 8. La diode laser 2 comporte une face émettrice 3 perpendiculaire au plan des figures.

À la sortie de la diode laser 2, dans un plan parallèle à la face émettrice 3, on peut considérer que la répartition d'amplitude du mode fondamental transverse et des premiers harmoniques de l'onde lumineuse émise par la diode laser est très confinée, typiquement de l'ordre de 1$\mu$m de large, selon un premier axe perpendiculaire au plan des figures 1 à 8. Son couplage avec un guide optique monomode, dont le profil est quasi symétrique et de largeur comprise classiquement entre 6 et 10$\mu$m selon le premier axe, ne pose pas de problème. Par contre, pour une diode laser monoruban large, les répartitions d'amplitude des différents modes transverses selon un second axe S' (figure 5), perpendiculaire à l'axe S dans le plan des figures 1 à 8, sont constituées par des fonctions sensiblement sinusoïdales à l'intérieur du ruban, qui constitue une zone de guidage, et de type exponentielles décroissantes, d'autant plus étendues que le numéro de l'harmonique est élevé, à l'extérieur du ruban. De manière analogue, pour une diode laser multiruban, les répartitions d'amplitude selon le second axe sont de type exponentiel. Dans les deux cas, le couplage avec un guide optique monomode, dont le profil est quasi-symétrique et de largeur comprise classiquement entre 6 et 10$\mu$m selon le second axe S', serait très peu efficace.

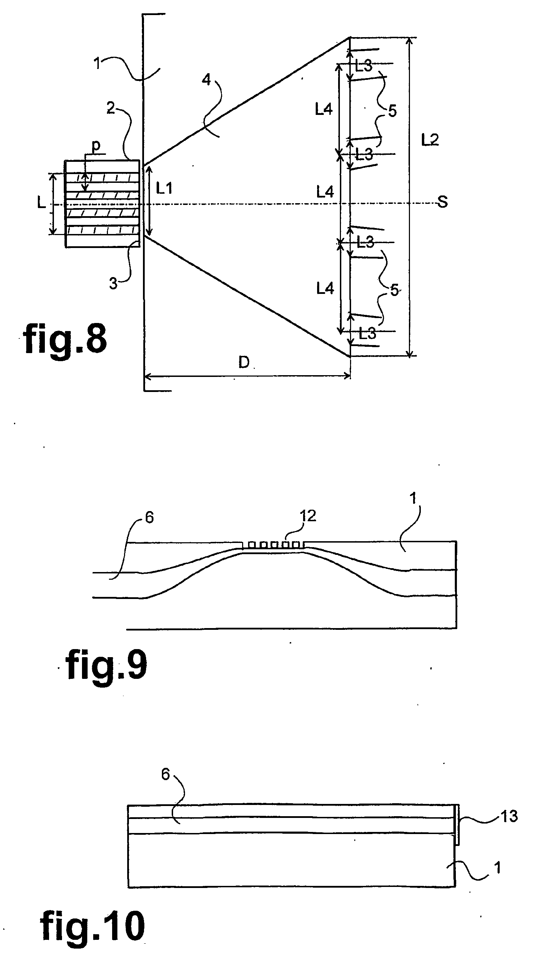

On peut montrer que les différents modes transverses émis par les deux types de diode laser 2 considérés forment, à la sortie de la diode laser 2, à une distance D (figures 6 à 8) de l'entrée du composant, des figures de diffraction de type franges d'interférence dont l'intensité lumineuse selon le second axe S', perpendiculaire à l'axe S dans le plan des figures 1 à 8, présente des lobes, ou pics de lumière. La largeur des lobes est prédéterminée et fonction de la longueur d'onde de la lumière émise par la diode laser, de la distance D entre la face d'entrée du composant de couplage 1 et le plan d'observation et de la largeur de la zone de guidage illuminée en entrée, c'est-à-dire la largeur L du ruban dans le cas d'une diode monoruban ou de l'ensemble du réseau multiruban (figure 8). Pour une diode laser monoruban un mode transverse particulier conduit à une figure de diffraction composée de deux lobes séparés, qui peuvent se superposer pour former un lobe unique correspondant au mode fondamental dans le cas où l'excitation de celui-ci serait privilégiée. Dans le cas d'une diode laser multiruban, on observe au moins deux lobes séparés. En pratique, l'amplitude des lobes diminue rapidement et l'on n'observe pas plus de quatre lobes d'amplitude notable, soit deux lobes pour une diode laser multiruban à fort coefficient de couplage entre les rubans et quatre lobes pour une diode laser multiruban à faible coefficient de couplage entre les rubans.

Les figures 1, 2 et 6 concernent, à titre d'exemple, un composant de couplage associé à une diode laser monoruban large excitée sur le mode fondamental. Celui-ci produit une figure de diffraction à un seul lobe dans un plan d'observation parallèle à la face émettrice 3 de la diode laser 2 et situé, selon l'axe S, à une distance au moins égale à D (figure 6) de l'entrée du composant de couplage.

Les figures 3, 4 et 7 concernent un composant de couplage associé à une diode laser 2 monoruban large ou multiruban à fort coefficient de couplage, produisant à une distance au moins égale à D une figure de diffraction à 2 lobes.

Les figures 5 et 8 concernent un composant de couplage associé à une diode laser 2 multiruban, à faible couplage entre les rubans, produisant à une distance au moins égale à D une figure de diffraction à 4 lobes significatifs.

Tous les composants de couplage décrits comportent une zone de guidage d'entrée 4, comprenant un guide d'onde ayant des caractéristiques spatiales destinées à assurer une injection optimale, dans le composant de couplage, de la lumière émise par la diode laser 2. La zone de guidage d'entrée 4 a une largeur d'entrée $L_1$ selon le second axe, perpendiculaire à l'axe S dans le plan des figures 1 à 8. La largeur d'entrée $L_1$ est supérieure à la largeur L du ruban ou du réseau multiruban de la diode laser 2. La zone de guidage d'entrée s'étend, selon l'axe S, sur une distance au moins égale à D à partir de l'entrée du composant de couplage, qui fait face à la face émettrice 3 de la diode laser 2. La largeur de la zone de guidage d'entrée peut rester constante (figure 1) ou s'élargir (figures 2 à 8) sur la distance D jusqu'à une largeur de sortie $L_2$ afin d'optimiser les conditions de propagation de la lumière dans cette zone et minimiser les pertes.

La zone de guidage d'entrée 4 forme également une zone de diffraction de longueur D destinée à permettre la diffraction planaire de la lumière injectée dans le composant de couplage. Dans le cas particulier du laser monoruban large émettant sur le mode fondamental et ne produisant qu'un seul lobe, les conditions particulières de la propagation font que la distance D peut être choisie proche de zéro. En pratique, la zone de guidage d'entrée doit toujours avoir une longueur minimum de quelques millimètres, selon l'axe S, pour assurer sa fonction de couplage avec la diode laser. La distance D est supérieure ou égale à 2,5mm, de référence comprise entre 10 et 25mm.

Comme représenté sur les figures 1 à 5, le composant de couplage comporte, en aval de la zone de guidage d'entrée 4 des moyens de filtrage présentant au moins un guide d'onde intermédiaire comportant une zone de rétrécissement adiabatique 5. La zone de rétrécissement adiabatique 5 est destinée à assurer une adaptation optimale, avec un minimum de pertes de propagation, entre la zone de guidage d'entrée 4 et une zone de sortie du composant de couplage comportant au moins un guide d'onde de sortie 6, avantageusement monomode transverse, réalisé de préférence en optique intégrée.

Dans les exemples de réalisation des figures 1 et 2, à un seul lobe de diffraction, la zone de rétrécissement adiabatique 5 prolonge le guide d'onde formant la zone de guidage d'entrée 4. Elle se rétrécit de manière régulière jusqu'aux dimensions d'un guide d'onde monomode 6, ayant classiquement un diamètre compris entre 5 et 10µm.

Selon l'invention, au moins deux fenêtres de filtrage 7 sont disposées en des emplacements prédéterminés du plan d'observation, constituant les entrées des zones de rétrécissement adiabatique 5. Dans les modes particuliers de réalisation des figures 3 à 5, respectivement à 2 ou 4 lobes de diffraction, le composant de couplage comporte respectivement 2 ou 4 guides intermédiaires avec des zones de rétrécissement adiabatique 5. Chaque zone de rétrécissement adiabatique 5 relie, au moyen d'un guide d'onde dont la largeur diminue régulièrement, une fenêtre de filtrage 7, de largeur $L_3$ le long du second axe précité (figures 6 à 8), à un guide d'onde de liaison, qui est de préférence monomode transverse, 8a, 8b (figures 3 et 4), 8c, 8d, 8e ou 8f (figures 5). Les fenêtres de filtrage 7, situées dans le plan d'observation précité, à la distance D de la face d'entrée du composant sont destinées à sélectionner les lobes de diffraction formés dans ce plan et à les injecter dans les zones de rétrécissement adiabatique 5 associées.

Une fenêtre de filtrage 7 est destinée à favoriser un mode transverse particulier de propagation de la lumière, c'est-à-dire à sélectionner des modes transverses particuliers. Les fenêtres de filtrage 7 sont réalisées très simplement, en optique intégrée dans le composant de couplage, en même temps que les zones d'entrée, de rétrécissement adiabatique et de sortie. Pour cela, le composant de couplage utilise la répartition d'amplitude de la figure de diffraction à la distance D de la face d'entrée du composant. Les fenêtres de filtrage 7 constituent, dans le plan d'observation précité, des ouvertures d'entrée des zones de rétrécissement adiabatique 5, ne laissant passer que les portions de lumière de la figure de diffraction situées aux emplacements sélectionnés.

Lorsqu'il n'y a qu'un seul lobe de diffraction, la largeur $L_3$ de la fenêtre de filtrage, correspondant à la largeur du lobe de diffraction, est de préférence égale à la largeur de sortie $L_2$ de la zone d'entrée (figures 1 et 2). Elle peut cependant être inférieure à celle-ci, comme représenté à la figure 6. Lorsqu'il y a 2 ou 4 lobes de diffraction, l'espacement entre les lobes selon le second axe précité est prédéterminé en fonction de la longueur d'onde de la lumière émise par la diode laser 2, de la distance D, de la largeur de la zone d'émission (ruban unique ou réseau multiruban) pour le mode transverse considéré et de l'ordre du mode transverse considéré. Les fenêtres de filtrage ont des dimensions (largeur $L_3$) et des positions (écartement $L_4$) choisies pour ne laisser passer que le mode transverse sélectionné, dont l'intensité lumineuse est maximale à l'emplacement du centre de la fenêtre de filtrage associée.

La longueur D de la zone de diffraction est calculée de telle façon que le phénomène de diffraction, à l'extrémité de la zone de diffraction où sont placées les fenêtres de filtrage 7, puisse être considéré comme la transformée de Fourier de la répartition d'amplitude de lumière à l'entrée de la zone de diffraction. Cela implique la relation suivante :

$$L^2/4D \leq \lambda/10 \quad \text{soit} \quad D \geq 10L^2/4\lambda,$$

dans laquelle L est la largeur de la zone de guidage illuminée en entrée et $\lambda$ la longueur d'onde de la lumière émise par la source lumineuse. À titre d'exemple, pour L=100$\mu$m et $\lambda$=0,98$\mu$m, on obtient D ≥ 25mm.

En pratique, il y a peu d'écart entre la répartition d'amplitude de diffraction et la transformée de Fourier souhaitée dès que la relation suivante est satisfaite :

$$L^2/4D \leq \lambda \quad \text{soit} \quad D \geq L^2/4\lambda$$

Dans l'exemple ci-dessus, on obtient ainsi D ≥ 2,5mm.

Les dimensions respectives des différentes zones sont, par exemple, les suivantes, pour une longueur d'onde $\lambda$=1,55$\mu$m, une largeur L=100$\mu$m et une largeur d'entrée L1≥100$\mu$m :

- Pour un lobe de diffraction (figures 1, 2 et 6) :

  ♦ pour D=10mm, L2≈L3≈300$\mu$m
  ♦ pour D=20mm, L2≈L3≈500 à 600$\mu$m

- Pour 2 lobes de diffraction (figures 3, 4 et 7), c'est-à-dire, par exemple, dans le cas d'une diode laser monoruban large dans lequel on privilégie le 6ème mode transverse ou dans une diode laser multiruban ayant un pas p de 17$\mu$m entre les rubans et émettant des faisceaux de l'ordre de 12$\mu$m de diamètre émis par chacun des rubans :

  ♦ pour D=10mm, L2≈800 à 900$\mu$m, L3≈200$\mu$m et L4≈600$\mu$m
  ♦ pour D=20mm, L2≈1,6 à 1,8mm, L3≈400$\mu$m et L4≈1,2mm

- Pour 4 lobes de diffraction (figures 5 et 8), c'est-à-dire, par exemple, pour une diode laser multiruban à faible couplage ayant un pas p de 17$\mu$m entre les rubans et des faisceaux de 6$\mu$m de diamètre émis par chacun des rubans :

  ♦ pour D=10mm, L3≈2$\lambda$D/L=200$\mu$m et L4≈$\lambda$D/p≈600$\mu$m
  ♦ pour D=20mm, L3≈400$\mu$m et L4=1,2mm

L'utilisation de plusieurs fenêtres de filtrage 7 permet la sélection de modes de la diode laser 2 plus élevés que le mode fondamental qui est sélectionné lorsqu'il y a une fenêtre unique. Cette sélection de mode d'ordre élevé permet d'avoir une meilleure stabilité d'émission de la diode laser dans la mesure où les modes d'ordre élevé possèdent une répartition d'intensité, composée de plusieurs lobes, qui met en jeu une meilleure uniformisation du pompage électrique dans la diode laser. On peut, en particulier, favoriser les lobes dont la distance entre lobes d'émission est de l'ordre de la longueur de diffusion Df des porteurs dans le matériau de la diode laser, c'est-à-dire typiquement quelques micromètres. Cette sélection conduit à une émission plus stable en réduisant la compétition entre les modes du laser. En effet, l'utilisation d'un mode harmonique transverse, à nombre de lobes plutôt élevé, permet de mieux répartir l'intensité émise sur toute la largeur du ruban, tout en utilisant au mieux le pompage électrique de la diode. À titre d'exemple, on peut privilégier un mode transverse compris entre les numéros 25 et 50, typiquement avec une longueur de diffusion Df de l'ordre de 2$\mu$m.

Dans tous les modes-de réalisation représentés, l'axe S constitue un axe de symétrie pour la diode laser 2, la zone d'entrée 4 et les fenêtres de filtrage 7.

Dans les composants de couplage comportant au moins deux fenêtres de filtrage 7 (figure 3 à 5), les zones de rétrécissement adiabatiques 5 sont disposées symétriquement de part et d'autre de l'axe S et sont, à leur origine, inclinées par rapport à l'axe S de manière à s'en écarter.

Dans la zone de sortie du composant de couplage, des jonctions Y, de type classique, permettent de rassembler les guides d'onde intermédiaires deux par deux pour aboutir au guide d'onde monomode 6 de sortie. Dans les modes particuliers de réalisation des figures 3 et 4, une seule jonction Y, 9, symétrique par rapport à l'axe S, relie les guides d'onde de liaison 8a et 8b au guide d'onde de sortie 6. Dans le mode particulier de réalisation de la figure 5, à 4 fenêtres de filtrage 7 et 4 zones de rétrécissement adiabatique 5, une cascade de jonctions Y est nécessaire. Ainsi, à la figure 5, une jonction Y 9a, dissymétrique, relie deux guides d'onde de liaison 8c et 8d disposés en sortie de deux zones 5 de rétrécissement adiabatique disposées d'un même côté de l'axe S, à un guide d'onde de liaison 8g. De même, une jonction Y 9b, dissymétrique, relie deux autres guides d'onde de liaison 8e et 8f, disposés de l'autre côté de l'axe S, à un autre guide d'onde de liaison 8h. Une troisième jonction Y, 9c, symétrique, disposée en cascade avec les jonctions Y9a et 9b, relie les guides d'onde de liaison 8g et 8h au guide d'onde de sortie 6.

Dans les composants de couplage comportant des guides d'onde de liaison, des déphaseur 10 peuvent, de manière classique, être situés sur l'un des guides de liaison (8a sur la figure 4, 8d, 8e et 8g sur la figure 5) pour rattraper d'éventuels déphasages géométriques entre les guides d'entrée des jonctions Y, de manière à assurer la mise en phase des signaux optiques entrant sur les jonctions Y et un rassemblement optimal sur le guide de sortie de la jonction Y concernée. De manière classique, les déphasages éventuels nécessaires peuvent être ajustés par chauffage localisé du guide d'onde considéré. Ceci peut être réalisé notamment par microchauffage par laser, par un chauffage de proximité par un microélément chauffant ou au moyen d'électrodes chauffantes placées au-dessus du guide d'onde.

Les jonctions Y peuvent éventuellement être remplacées par des coupleurs directionnels. Dans ce cas, les deux entrées du coupleur sont de préférence en quadrature de phase pour rassembler deux ondes optiques d'entrée sur un seul guide d'onde. Les déphaseurs 10 sont alors disposés en conséquence.

Le composant de couplage décrit ci-dessus peut présenter des pertes de puissance trop importantes. Pour y remédier, il est associé à des moyens d'amplification d'un mode de l'onde lumineuse émise par la source de lumière. Selon un mode de réalisation préférentiel, des éléments réflecteurs, ou éléments de renvoi, associés à la zone de sortie, assurent un retour (« feedback ») d'une partie de la lumière transportée par le guide d'onde de sortie 6 en direction de la diode laser 2. Les éléments de renvoi doivent avoir un coefficient de réflexion élevé, mais inférieur à 1 pour permettre d'obtenir la puissance désirée en sortie du composant de couplage. Grâce à ces éléments de renvoi, le composant de couplage peut former avec la diode laser 2, multimode transverse, un laser de puissance monomode transverse à cavité laser étendue, oscillant sur le mode transverse sélectionné par le composant de couplage et fournissant une puissance lumineuse optimale à la sortie du guide d'onde monomode de sortie 6. La diode laser 2 comporte classiquement une cavité laser interne délimitée par une face arrière réfléchissante 11 et par la face émettrice 3. La face émettrice 3, normalement réfléchissante, est traitée de manière à former une face externe antireflet, ou recouverte par une couche antireflet, de manière à réduire au minimum le taux de lumière réfléchi par la face émettrice 3, éviter toute oscillation dans la cavité laser interne de la diode laser 2 et privilégier l'oscillation laser dans une cavité laser étendue délimitée, d'une part, par la face arrière réfléchissante 11 de la diode laser 2 et, d'autre part, par les éléments de renvoi disposés dans la zone de sortie du composant de couplage. Une couche antireflet peut éventuellement être réalisée sur la face d'entrée du composant de couplage. Elle n'est cependant pas indispensable compte tenu du faible coefficient de réflexion naturelle du composant de couplage. Par contre le traitement antireflet de la face émettrice 3 est indispensable compte tenu de l'indice de réfraction élevé des matériaux semi-conducteurs utilisés dans les diodes laser.

Selon un mode de réalisation préférentiel des éléments de renvoi, illustré aux figures 1 à 5 et 9, ces éléments sont constitués par un réseau de Bragg 12 (réseau de diffraction) réalisé sur le guide d'onde de sortie 6. Il pourrait éventuellement être disposé à l'extérieur du composant de couplage sur un guide d'onde connecté au guide d'onde de sortie 6. Le réseau de Bragg assure à la fois la réflexion recherchée et une fonction de sélection en longueur d'onde. Ceci permet, par exemple, d'accorder la largeur spectrale de l'émission laser dans la cavité laser étendue à la largeur spectrale optimale de pompage d'un amplificateur optique.

Avec un réseau de Bragg à fort couplage, comportant un petit nombre de traits pour un coefficient de réflexion prédéterminé, la sélectivité en longueur d'onde est faible et la cavité laser étendue oscille sur un spectre relativement large. Par contre, avec un réseau de Bragg à faible couplage, comportant un grand nombre de traits pour un coefficient de réflexion prédéterminé, la sélectivité en longueur d'onde est élevée et la cavité laser étendue oscille sur un spectre étroit. Le choix du coefficient de couplage et du nombre de traits du réseau de Bragg permet, de manière connue, d'ajuster le coefficient de réflexion et la largeur du spectre émis, qui peut ainsi être optimisé pour assurer un rendement de pompage optimum d'un amplificateur optique.

Le réseau de Bragg peut être réalisé de toute manière connue, par exemple par gravure sèche, par gravure humide (attaque chimique), par photoinscription, par diffusion d'ions localisée à travers un masque, etc...

Les réseaux de Bragg gravés permettent généralement d'obtenir des coefficients de couplage élevés. Pour renforcer le coefficient de couplage, dans le cas où le guide d'onde de sortie 6 est réalisé par échange d'ions dans un substrat de verre, il est possible d'utiliser un guide de surface à fort confinement. Cette technique, connue, est illustrée à la figure 9 qui représente, vue de côté, un mode particulier de réalisation d'une extrémité de la zone de sortie d'un composant de couplage. Le guide d'onde de sortie 6 comporte, en entrée, sur la partie gauche de la figure 9, une première partie à faible confinement, enterrée. Le guide d'onde 6 comporte ensuite, de manière localisée en regard du réseau de Bragg 12 gravé à la surface du substrat 1, une seconde partie à fort confinement, plus étroite, affleurant à la surface du substrat. Le guide d'onde 6 comporte ensuite, en sortie, sur la partie droite de la figure 9, une troisième partie à faible confinement, enterrée, destinée à être couplée, à la sortie du composant de couplage, à un élément optique tel qu'un guide d'onde optique intégré ou à une fibre optique. Le guide d'onde de sortie 6 présente des dimensions et une profondeur qui varient régulièrement entre la première et la seconde partie et entre cette dernière et la troisième partie. Ce type de réalisation permet à la fois de profiter du renforcement du coefficient de couplage avec le réseau de Bragg 12 obtenu, grâce à l'utilisation d'un guide de surface à fort confinement, et d'une connexion facile du composant de couplage avec un guide d'onde optique ou une fibre optique, grâce à l'utilisation d'un guide d'onde à faible confinement, enterré, dans les première et troisième partie du guide d'onde de sortie 6.

Si le coefficient de couplage avec le réseau de Bragg 12 n'a pas besoin d'être élevé, le guide d'onde de sortie 6 peut être constitué par un guide à faible confinement dans la zone de couplage.

Le réseau de Bragg 12 peut être disposé perpendiculairement à l'axe S de propagation de la lumière dans le guide d'onde de sortie 6, comme représenté sur les figures 1 à 5 ou être incliné par rapport à cet axe d'un angle différent de 90°. On peut utiliser un réseau de Bragg 12 à pas constant ou à pas variable.

Un autre mode de réalisation des éléments de renvoi est illustré à la figure 10, qui représente, en vue de côté, un mode particulier de réalisation d'une extrémité de la zone de sortie d'un composant de couplage. Dans ce mode de réalisation, un élément réflecteur 13 est disposé à l'extrémité de sortie du composant de couplage (à droite sur la figure 10). L'élément réflecteur doit avoir une réflectivité élevée, mais inférieure à 1, et une transmission faible. Il peut être sélectif en longueur d'onde. Il est, de préférence, formé par un dépôt métallique ou par un dépôt multicouche réflecteur, constituant un miroir, dichroïque ou non, sur la face de sortie du composant de couplage, à l'extrémité de sortie du guide d'onde de sortie 6. Pour une bonne sélection des modes, il peut comporter un filtre spectral collé sur la couche réfléchissante.

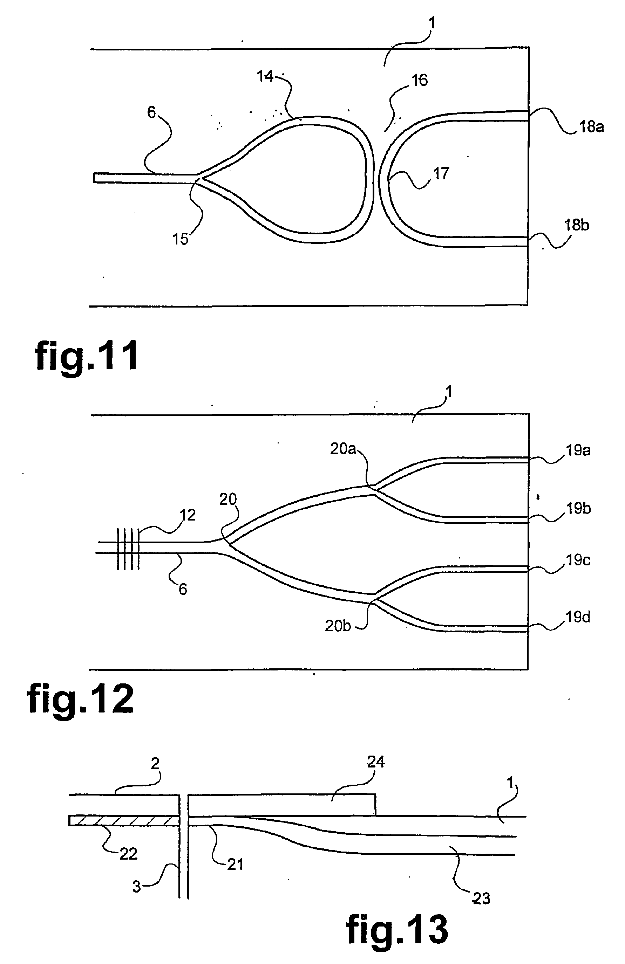

Un troisième mode de réalisation des éléments de renvoi est illustré à la figure 11, qui représente, en vue de dessus, un mode particulier de réalisation d'une extrémité de la zone de sortie d'un composant de couplage. Dans ce mode de réalisation, le guide d'onde de sortie 6 présente à son extrémité de sortie une boucle fermée 14 assurant, par l'intermédiaire d'une jonction Y 15 le retour sur elle-même de la lumière guidée par le guide d'onde de sortie 6.

L'extraction d'une partie de la lumière guidée dans la boucle 14 est assurée par un coupleur directionnel 16. Sur la figure 11, le coupleur directionnel est constitué par la bouche 14 et un guide d'onde 17, réalisés dans le substrat 1, comportant une partie de couplage à proximité d'une partie de la boucle 14 et deux sorties symétriques 18a et 18b. On obtient dans ce cas deux faisceaux de lumière en sortie du composant du couplage.

Plus généralement, il est possible de générer plusieurs faisceaux de lumière en sortie du composant de couplage, à partir d'un guide d'onde de sortie 6. Un mode particulier de réalisation d'une extrémité de la zone de sortie d'un composant de couplage, représenté à la figure 12 en vue de dessus, comporte 4 sorties 19a, 19b, 19c et 19d, obtenues au moyen d'une cascade de jonctions Y 20 puis 20a et 20b disposées en aval du réseau de Bragg 12. Le nombre, pair, de sorties disponibles est fonction du nombre de jonctions Y disposées en série. Il est ainsi possible de fournir des signaux de pompe à plusieurs amplificateurs optiques à partir d'une seule diode laser de puissance, dans la mesure où le composant de couplage selon l'invention permet de générer des puissances de sortie élevées. La subdivision du guide d'onde de sortie 6 étant réalisée en aval des éléments de renvoi (réseau de Bragg sur la figure 11), un seul élément de renvoi peut être utilisé pour l'ensemble des sorties.

La diode laser 2 et le composant de couplage sont, de préférence, couplés bout à bout (« butt coupling »), la face émettrice 3 de la diode laser étant placée face à la zone d'entrée du composant de couplage (figures 1 à 8 et 13 à 15). Ceci permet d'obtenir un laser de puissance monomode à cavité étendue très compact. Il est souhaitable de minimiser les pertes de couplage entre la diode laser 2 et le composant de couplage. Les dimensions des différents éléments décrits en référence aux figures 1 à 8 tiennent compte de cette nécessité dans le plan des figures 1 à 8. Par contre, dans un plan perpendiculaire au plan des figures 1 à 8, c'est-à-dire parallèle à la face émettrice 3, il y a en général une différence importante de confinement entre la structure émettrice de la diode laser 2, qui fournit un faisceau très confiné spatialement (typiquement de l'ordre de $1\mu m$ de large), donc très divergent, et la structure d'entrée du composant de couplage qui présente un confinement moyen ou faible. Même en minimisant la distance entre la diode laser 2 et le composant de couplage à quelques microns, le recouvrement des profils des modes guidés de la diode laser et du composant de couplage n'est pas forcément optimal. Ceci peut conduire à des pertes d'insertion élevées dans la cavité étendue.

Pour minimiser ce type de pertes, la zone d'entrée du composant de couplage est, de préférence, constituée par une structure guide d'onde d'entrée à très fort confinement, avec un profil de mode suivant le premier axe précité (axe vertical) de dimensions voisines de celui de la diode laser, c'est-à-dire de l'ordre du micron.

La figure 13 illustre, en vue de côté, un mode de réalisation particulier du couplage diode composant présentant les caractéristiques désirées. La zone d'entrée du composant de couplage comporte, en entrée, un guide d'onde 21 à fort confinement, dans la direction perpendiculaire au plan du substrat, présentant une variation d'indice élevée, en surface ou peu enterré dans le substrat optique 1. Comme représenté sur la figure 13, le guide d'onde 21 mince, est disposé face à la partie émissive 22 de la diode laser 2 constituée par la jonction semi-conductrice de celle-ci. Cependant, les guides d'onde à fort confinement, notamment réalisés par échange ionique dans les verres, présentent des pertes de propagation plus élevées que les guides enterrés à faible confinement et il n'est donc pas souhaitable de les utiliser sur la totalité du composant optique. Sur la figure 13, le guide d'onde à fort confinement 21 est localisé à l'extrémité d'entrée de la zone d'entrée et prolongé par un guide d'onde 23 à faible confinement, plus épais, enterré. Une couche de symétrisation 24 est de préférence, disposée sur le substrat 1 pour obtenir un profil de mode guidé le plus voisin possible de celui de la diode laser suivant un axe perpendiculaire à la jonction semi-conductrice de la diode laser. La couche de symétrisation a un indice de réfraction égal ou inférieur à celui du substrat 1. Elle peut être réalisée en silice, par exemple, si le substrat 1 est en verre.

Ce mode de réalisation permet d'améliorer l'injection de lumière provenant de la diode laser 2 dans le composant de couplage. Il ne permet cependant pas d'optimiser totalement le couplage car le guide d'onde 21, obtenu par échange d'ions dans le substrat 1, conduit néanmoins à des modes moins confinés que ceux émis par la diode laser dans la direction du premier axe précité (axe vertical), perpendiculairement à la jonction de la diode laser.

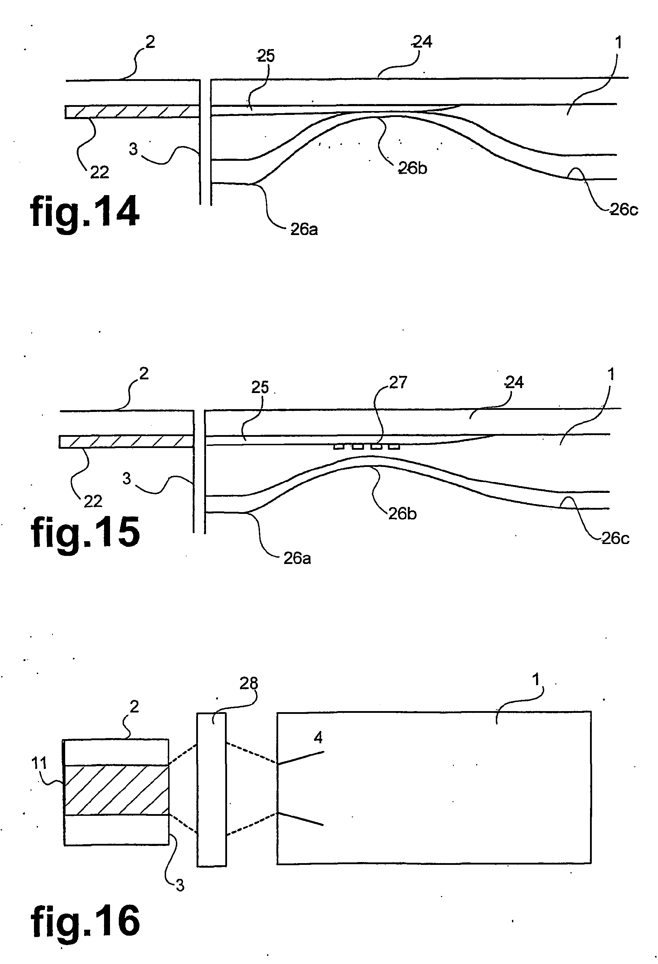

Les modes de réalisation particuliers du couplage diode-composant illustrés, en vue de côté, sur les figures 14 et 15 permettent de s'approcher des structures de modes de la diode laser 2 et, ainsi, d'améliorer encore le couplage selon le premier axe.

Sur les figures 14 et 15, un guide d'onde 25, à fort confinement dans la direction perpendiculaire au plan du substrat, est formé à la surface du substrat optique 1. Le guide d'onde 25 est superposé à un second guide d'onde réalisé par échange d'ions dans le substrat 1 et comportant, de manière analogue au guide 6 de la figure 9, éventuellement une première partie 26a à faible confinement, enterrée, épaisse, se prolongeant par une seconde partie 25b, de couplage, à fort confinement, plus mince, en surface, elle-même prolongée par une troisième partie 26c à faible confinement analogue à la première partie 26a. Le guide d'onde 25 peut être réalisé par un dépôt d'une mince couche diélectrique (de l'ordre de 0,1μm par exemple), d'indice élevé à la surface du substrat optique 1. À titre d'exemple, il peut être réalisé en nitrure de silicium, d'indice 1,97, ou en alumine déposés par dépôt chimique phase vapeur assisté par plasma (PECVD, « Plasma Enhanced Chemical Vapor Deposition ») ou par pulvérisation cathodique.

Le guide d'onde 25 constitue l'entrée de la zone d'entrée 4 et est couplé au second guide d'onde dont la troisième partie 26c constitue la sortie de la zone d'entrée. Le couplage entre les guides d'onde superposés, plus précisément entre le guide d'onde 25 et la seconde partie 26b, de couplage, du second guide d'onde peut être réalisé soit par une transition douce obtenue par une diminution régulière de l'épaisseur de la couche à indice élevé constituant le guide 25 (figure 14), soit par l'intermédiaire d'un réseau de Bragg 27 réalisé à la surface du substrat 1 au niveau de la seconde partie 26b (figure 15). Dans ce cas, le pas du réseau de Bragg 27 est calculé de manière à adapter les constantes de propagation des modes de propagation du guide d'onde 25 et de la partie 26b. Si cette solution est choisie, elle peut être réalisée dans le même cycle technologique que le réseau de Bragg illustré à la figure 9.

Comme à la figure 13, une couche de symétrisation 24, d'indice voisin ou inférieur à celui du substrat optique 1, est de préférence déposée sur le substrat.

Le couplage entre la diode laser 2 et le composant de couplage peut également être réalisé par l'intermédiaire d'éléments optiques d'adaptation 28 externes, comme représenté, en vue de dessus à la figure 16. Il n'est alors en général pas nécessaire d'utiliser les structures d'adaptation des profils de mode selon le premier axe décrit ci-dessus, les éléments optiques d'adaptation 28 étant dimensionnés de manière appropriée au transfert des profils de mode de la diode laser 2 au composant de couplage. Cette solution est néanmoins moins compacte que les précédentes et nécessite un alignement entre les 3 éléments concernés, la diode laser 2, le composant de couplage et les éléments optiques d'adaptation 28, parfois constitués de plusieurs lentilles.

**Revendications**

**1.** Composant de couplage réalisé en optique intégrée, destiné à adapter une source lumineuse à un élément d'optique guidée et comportant un substrat optique (1), dans lequel sont formés des guides d'onde, et successivement une zone de guidage d'entrée (4), disposée en regard de la source, une zone de sortie comportant au moins un guide d'onde de sortie (6), monomode, plus étroit que la zone de guidage d'entrée, et des moyens de filtrage comportant au moins une zone de rétrécissement adiabatique (5) connectant la zone de guidage d'entrée et la zone de sortie, composant **caractérisé en ce que** la zone de guidage d'entrée définit une zone de diffraction de longueur prédéterminée (D) entre l'entrée du composant et un plan d'observation, au moins deux fenêtres de filtrage (7), disposées en des emplacements prédéterminés du plan d'observation, constituant les entrées des zones de rétrécissement adiabatique (5), de manière à guider une onde lumineuse de la source vers la zone de sortie en sélectionnant un des modes de ladite onde.

**2.** Composant selon la revendication 1, **caractérisé en ce que** la longueur (D) de la zone de diffraction est supérieure ou égale à $L^2/4\lambda$, L étant la largeur de la zone de guidage illuminée en entrée et $\lambda$ la longueur d'onde de la lumière émise par la source lumineuse.

3. Composant selon la revendication 2, **caractérisé en ce que** la longueur (D) de la zone de diffraction est supérieure ou égale à 2,5mm.

4. Composant selon l'une quelconque des revendications 1 à 3, **caractérisé en ce qu'**il comporte deux fenêtres de filtrage (7), deux zones de rétrécissement adiabatique (5) connectant la zone de guidage d'entrée (4) à deux guides d'onde de liaison associés (8a, 8b), et une jonction Y (9) connectant les guides d'onde de liaison (8a, 8b ) au guide d'onde de sortie (6).

5. Composant selon l'une quelconque des revendications 1 à 3, **caractérisé en ce qu'**il comporte quatre fenêtres de filtrage (7), et quatre zones de rétrécissement adiabatique (5) connectant la zone de guidage (4) à quatre guides d'onde de liaison associés (8c, 8d, 8e, 8f), connectés, par l'intermédiaire d'une cascade de jonction Y (9a, 9b, 9c) au guide d'onde de sortie (6).

6. Composant selon l'une quelconque des revendications 1 à 5, **caractérisé en ce que** des moyens réflecteurs (12, 13, 14) sont associés au guide d'onde de sortie (6), et **en ce que** le composant est destiné à coopérer avec une source lumineuse multimode transverse (2), comportant une face arrière réfléchissante (11) et une face émettrice (3), pour former un laser de puissance monomode transverse, la face émettrice de la source lumineuse étant traitée de manière à former une face externe antireflet, de manière à délimiter une cavité laser étendue oscillant sur un seul mode prédéterminé entre ladite face arrière et les moyens réflecteurs (12, 13, 14).

7. Composant selon la revendication 6, **caractérisé en ce que** les moyens réflecteurs comprennent un réseau de Bragg (12).

8. Composant selon la revendication 6, **caractérisé en ce que** les moyens réflecteurs comprennent une couche réfléchissante (13) disposée à une extrémité de sortie de la zone de sortie.

9. Composant selon la revendication 6, **caractérisé en ce que** le guide d'onde de sortie (6) présente à son extrémité de sortie une boucle fermée (14) formant les moyens réflecteurs et assurant, par l'intermédiaire d'une jonction Y (15), le retour de la lumière sur elle-même, un coupleur directionnel (16) associé à la boucle fermée formant la sortie (18a, 18b) du composant de couplage.

10. Composant selon l'une quelconque des revendications 1 à 9, **caractérisé en ce que**, la source lumineuse (2) est une diode laser monoruban large, et **en ce que** la zone de guidage d'entrée (4) du composant a une largeur d'entrée ($L_1$) supérieure ou égale à la largeur (L) du ruban.

11. Composant selon l'une quelconque des revendications 1 à 9, **caractérisé en ce que,** la source lumineuse (2) est une diode laser comportant un réseau multiruban, et **en ce que** la zone de guidage d'entrée (4) du composant a une largeur d'entrée ($L_1$) supérieure ou égale à la largeur (L) du réseau multiruban.

12. Composant selon l'une quelconque des revendications 1 à 11, **caractérisé en ce que** la zone de guidage d'entrée comporte, en entrée, un guide d'onde (21, 25) à fort confinement de la lumière dans une direction perpendiculaire au plan du substrat.

13. Composant selon la revendication 12, **caractérisé en ce que** le guide d'onde (25) à fort confinement de la zone d'entrée est formé sur la surface du substrat optique (1) et couplé avec un second guide d'onde auquel il est superposé, le second guide d'onde étant formé par échange d'ions dans le substrat optique (1) et comportant une partie de couplage (26b), à fort confinement, et une partie (26c) à faible confinement constituant la sortie de la zone d'entrée.

14. Composant selon la revendication 13, **caractérisé en ce que** le couplage entre le guide d'onde (25) à fort confinement de la zone d'entrée et la partie de couplage (26b) du second guide d'onde est réalisé par une diminution régulière de l'épaisseur du guide d'onde (25) à fort confinement.

15. Composant selon la revendication 13, **caractérisé en ce que** le couplage entre le guide d'onde (25) à fort confinement de la zone d'entrée et la partie de couplage (26b) du second guide d'onde est réalisé par un réseau de Bragg (27), réalisé à la surface du substrat (1) au niveau de la partie de couplage (26b) du second guide d'onde.

16. Laser de puissance monomode comportant une diode laser (2) multimode comportant une cavité laser interne délimitée par une face arrière réfléchissante (11) et une face émettrice (3), **caractérisé en ce qu'**il comporte un composant de couplage selon l'une quelconque des revendications 1 à 15 et **en ce que** la face émettrice (3) de la diode laser (2) est traitée de manière à former une face externe antireflet, de manière à délimiter une cavité laser étendue entre ladite face arrière (11) et des moyens réflecteurs (12, 13, 14).

**Claims**

1. An integrated-optics coupling component, designed to adapt a light source to a guided optics element and comprising an optics substrate (1), wherein are formed waveguides and successively an input guide zone (4) arranged facing the source, an output zone comprising at least one, monomode, output waveguide (6), narrower than the input guide zone, and filtering means comprising at least one adiabatic tapering zone (5) connecting the input guide zone and the output zone, component **characterized in that** the input guide zone defines a diffraction zone of predetermined length (D) between the input of the component and an observation plane, at least two filtering windows (7), arranged at predetermined locations of the observation plane, constituting the inputs of the adiabatic tapering zones (5), so as to guide a light wave from the source to the output zone while selecting one of the modes of said wave.

2. Component according to claim 1, **characterized in that** the length (D) of the diffraction zone is greater than or equal to $L^2/4\lambda$, L being the width of the illuminated input guide zone and $\lambda$ the wavelength of the light emitted by the light source.

3. Component according to claim 2, **characterized in that** the length (D) of the diffraction zone is greater than or equal to 2.5mm.

4. Component according to any one of claims 1 to 3, **characterized in that** it comprises two filtering windows (7), two adiabatic tapering zones (5) connecting the input guide zone (4) to two associated connecting waveguides (8a, 8b), and a Y-junction (9) connecting the connecting waveguides (8a, 8b) to the output waveguide (6).

5. Component according to any one of claims 1 to 3, **characterized in that** it comprises four filtering windows (7) and four adiabatic tapering zones (5) connecting the input guide zone (4) to four associated connecting waveguides (8c, 8d, 8e, 8f), connected by means of a cascade of Y-junctions (9a, 9b, 9c) to the output waveguide (6).

6. Component according to any one of claims 1 to 5, **characterized in that** reflecting means (12, 13, 14) are associated with the output waveguide (6) and **in that** the component is designed to cooperate with a transverse multimode light source (2) comprising a reflecting rear face (11) and an emitting face (3) to form a transverse monomode power laser, the emitting face of the light source being treated so as to form an antiglare external face, so as to define an extended laser cavity oscillating on a single predetermined mode between said rear face and the reflecting means (12, 13, 14).

7. Component according to claim 6, **characterized in that** the reflecting means comprise a Bragg grating (12).

8. Component according to claim 6, **characterized in that** the reflecting means comprise a reflecting layer (13) arranged at an output end of the output zone.

9. Component according to claim 6, **characterized in that** the output waveguide (6) presents at its output end a closed loop (14) forming the reflecting means and ensuring feedback of the light on itself, by means of a Y-junction (15), a directional coupler (16) associated to the closed loop forming the output (18a, 18b) of the coupling component.

10. Component according to any one of claims 1 to 9, **characterized in that** the light source (2) is a broad single-stripe laser diode and **in that** the input guide zone (4) of the component has an input width ($L_1$) greater than or equal to the width (L) of the stripe.

11. Component according to any one of claims 1 to 9, **characterized in that** the light source (2) is a laser diode comprising a multi-stripe arrangement and **in that** the input guide zone (4) of the component has an input width ($L_1$) greater than or equal to the width (L) of the multi-stripe arrangement.

12. Component according to any one of claims 1 to 11, **characterized in that** the input guide zone comprises on input a waveguide (21, 25) with large light confinement in a direction perpendicular to the plane of the substrate.

13. Component according to claim 12, **characterized in that** the waveguide (25) with large light confinement of the input zone is formed on the surface of the optics substrate (1) and coupled with a second waveguide whereon it is superposed, the second waveguide being formed by ion exchange in the optics substrate (1) and comprising a coupling part (26b) with large confinement and a low-confinement part (26c) constituting the output of the input zone.

14. Component according to claim 13, **characterized in that** coupling between the waveguide (25) with large confinement of the input zone and the coupling part (26b) of the second waveguide is achieved by regular reduction of the thickness of the waveguide (25) with large confinement.

15. Component according to claim 13, **characterized in that** coupling between the waveguide (25) with large confinement of the input zone and the coupling part (26b) of the second waveguide is achieved by a Bragg grating (27), made at the surface of the substrate (1) at the level of the coupling part (26b) of the second waveguide.

16. Monomode power laser comprising a multimode laser diode (2) comprising an internal laser cavity bounded by a reflecting rear face (11) and an emitting face (3), **characterized in that** it comprises a coupling component according to any one of claims 1 to 15 and **in that** the emitting face (3) of the laser diode (2) is treated so as to form an antiglare external face, so as to define an extended laser cavity between said rear face (11) and reflecting means (12, 13, 14).

**Patentansprüche**

1. Integriertes, optisches Kopplungsbauteil, das dazu bestimmt ist eine Lichtquelle an ein optisch geführtes Element anzupassen und ein optisches Substrat (1) umfasst, in dem Wellenleiter gebildet sind, sowie nacheinander eine Eintrittsführungszone (4), die gegenüber der Lichtquelle angeordnet ist, eine Austrittszone, die mindestens einen Einmoden-Ausgangswellenleiter (6) umfasst, der schmaler ist als die Eintrittsführungszone, und Filterungsmittel, die mindestens eine adiabatische Verengungszone (5) umfassen, die die Eintrittsführungszone und die Austrittszone miteinander verbindet, Bauteil, **dadurch gekennzeichnet, dass** die Eintrittsführungszone eine Diffraktionszone vorbestimmter Länge (D) zwischen dem Eingang des Bauteils und einer Beobachtungsebene bildet, wobei mindestens zwei Filterfenster (7), die an vorbestimmten Stellen der Beobachtungsebene angeordnet sind, die Eingänge der adiabatischen Verengungszonen (5) bilden, sodass eine Lichtwelle von der Quelle bis zur Austrittszone geführt wird, wobei eine der Moden der Welle ausgewählt wird.

2. Bauteil nach Anspruch 1, **dadurch gekennzeichnet, dass** die Länge (D) der Diffraktionszone größer oder gleich $L^2/4\lambda$ ist, wobei L die Breite der am Eingang beleuchteten Führungszone und $\lambda$ die Wellenlänge des von der Lichtquelle ausgestrahlten Lichts ist.

3. Bauteil nach Anspruch 2, **dadurch gekennzeichnet, dass** die Länge (D) der Diffraktionszone größer oder gleich 2,5 mm ist.

4. Bauteil nach einem der Ansprüche 1 bis 3, **dadurch gekennzeichnet, dass** es zwei Filterfenster (7), zwei adiabatische Verengungszonen (5), die die Eintrittsführungszone (4) mit zwei zugehörigen Verbindungs-Wellenleitern (8a, 8b) verbinden, und eine Verbindung Y (9), welche die Verbindungs-Wellenleiter (8a, 8b) mit dem Ausgangswellenleiter (6) verbinden, umfasst.

5. Bauteil nach einem der Ansprüche 1 bis 3, **dadurch gekennzeichnet, dass** es vier Filterfenster (7) und vier adiabatische Verengungszonen (5), die die Eintrittsführungszone (4) mit vier zugeordneten Verbindungs-Wellenleitern (8c, 8d, 8e, 8f) verbinden, die mittels einer Verbindungskaskade Y (9a, 9b, 9c) mit dem Ausgangswellenleiter (6) verbunden sind, umfasst.

6. Bauteil nach einem der Ansprüche 1 bis 5, **dadurch gekennzeichnet, dass** dem Ausgangswellenleiter (6) Reflexionsmittel (12, 13, 14) zugeordnet sind, sowie **dadurch**, dass das Bauteil vorgesehen ist, mit einer Transversalen-Multimoden-Lichtquelle (2) zusammenzuwirken, die eine reflektierende Rückseite (11) und eine ausstrahlende Seite (3) aufweist, um einen Transversalen- Monomoden-Hochleistungslaser zu bilden, wobei die ausstrahlende Seite der Lichtquelle so bearbeitet ist, dass sie eine Antireflex-Außenseite bildet um einen breiten Laserresonator zu begrenzen, der nur auf einer einzigen vorbestimmten Mode zwischen der Rückseite und den Reflexionsmitteln (12, 13, 14) oszilliert.

7. Bauteil nach Anspruch 6, **dadurch gekennzeichnet, dass** die Reflexionsmittel ein Braggnetz (12) umfassen.

8. Bauteil nach Anspruch 6, **dadurch gekennzeichnet, dass** die Reflexionsmittel eine reflektierende Schicht (13) umfassen, die an einem Ausgangsende der Austrittszone angeordnet ist.

9. Bauteil nach Anspruch 6, **dadurch gekennzeichnet, dass** der Ausgangswellenleiter (6) an seinem Ausgangsende eine geschlossene Schleife (14) hat, die die Reflexionsmittel bildet und mittels einer Verbindung Y (15) die Umkehr des Lichts zu sich selbst sicherstellt, wobei ein mit der geschlossenen Schleife zusammenhängender Richtungskoppler (16) den Ausgang (18a, 18b) des Kopplungsbauteils bildet.

10. Bauteil nach einem der Ansprüche 1 bis 9, **dadurch gekennzeichnet, dass** die Lichtquelle (2) eine Monobreitband-Laserdiode ist und dass der Eintrittsführungsbereich (4) des Bauteils eine Eintrittsbreite ($L_1$) hat, die größer als die oder gleich der Breite (L) des Bands ist.

11. Bauteil nach einem der Ansprüche 1 bis 9, **dadurch gekennzeichnet, dass** die Lichtquelle (2) eine Laserdiode ist, die ein Multibandnetz aufweist, und dass der Eintrittsführungsbereich (4) des Bauteils eine Eingangsbreite ($L_1$) hat, die größer als die oder gleich der Breite (L) des Multibandnetzes ist.

**12.** Bauteil nach einem der Ansprüche 1 bis 11, **dadurch gekennzeichnet, dass** die Eintrittsführungszone am Eingang einen Wellenleiter (21, 25) mit starker Eingrenzung des Lichts in einer zur Ebene des Substrats lotrechten Richtung umfasst.

**13.** Bauteil nach Anspruch 12, **dadurch gekennzeichnet, dass** der Wellenleiter (25) mit starker Eingrenzung der Eintrittszone auf der Oberfläche des optischen Substrats (1) gebildet und mit einem zweiten Wellenleiter gekoppelt ist, über dem er angeordnet ist, wobei der zweite Wellenleiter durch Ionenaustausch in dem optischen Substrat (1) gebildet wird und einen Koppelteil (26b) mit starker Eingrenzung und einen Bereich (26c) mit geringer Eingrenzung umfasst, der den Ausgang der Eintrittszone bildet.

**14.** Bauteil nach Anspruch 13, **dadurch gekennzeichnet, dass** die Kopplung zwischen dem Wellenleiter (25) mit starker Eingrenzung der Eintrittszone und der Kopplungszone (26b) des zweiten Wellenleiters durch eine gleichmäßige Verringerung der Dicke des Wellenleiters (25) mit starker Eingrenzung erfolgt.

**15.** Bauteil nach Anspruch 13, **dadurch gekennzeichnet, dass** die Kopplung zwischen dem Wellenleiter (25) mit großer Eingrenzung der Eintrittszone und dem Kopplungsbereich (26b) des zweiten Wellenleiters durch ein Braggnetz (27) erfolgt, das auf der Oberfläche des Substrats (1) im Bereich des Kopplungsbereichs hergestellt ist.

**16.** Einmoden-Hochleistungslaser, der eine Multimodenlaserdiode (2) umfasst, die einen Innenresonator umfasst, der von einer reflektierenden Rückseite (11) und einer ausstrahlenden Seite (3) begrenzt wird, **dadurch gekennzeichnet, dass** er einen Kopplungsbauteil nach einem der Ansprüche 1 bis 15 umfasst, sowie dadurch, dass die ausstrahlende Seite (3) der Laserdiode (2) so behandelt ist, dass sie eine Antireflex-Außenseite bildet um einen breiten Laserresonator zwischen der genannten Rückseite (11) und den Reflexionsmitteln (12, 13, 14) zu begrenzen.

EP 1 390 786 B1

**fig.1**

**fig.2**

**fig.3**

**fig.4**

13

fig.5

fig.6

fig.7

14

**fig.8**

**fig.9**

**fig.10**

**fig.11**

**fig.12**

**fig.13**

fig.14

fig.15

fig.16

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5513196 A